# EUROPEAN PATENT APPLICATION

(11) **EP 4 693 363 A1**
(43) Date of publication of application: **11.02.2026**
(21) Application number: 25194294.2
(22) Date of filing: 06.08.2025
(51) Int. Cl.: H01J 37/32

(54) **SUBSTRATE PROCESSING EQUIPMENT HAVING MEASUREMENT MODULE FOR MEASURING CURRENT, VOLTAGE AND POWER OF OUTPUT POWER**

(30) Priority: 06.08.2024 KR 20240104757
(71) Applicant: Korea Institute of Fusion Energy, Daejeon 34133 (KR)
(72) Inventor: KIM, Jongsik, Gunsan-si, Jeollabuk-do (KR)
(74) Representative: ABG Intellectual Property Law, S.L.

(57) **Abstract**

The present invention relates to a substrate processing equipment, and more particularly, to a substrate processing equipment equipped with a current, voltage and power measurement module for measuring the current/voltage applied for generating and maintaining plasma during substrate processing using plasma, and further for measuring the power of incident and reflected waves. The present invention discloses a substrate processing equipment comprising a process chamber forming a sealed processing space in which plasma is formed to perform substrate processing; a substrate support unit disposed in the processing space on which a substrate is seated; and a gas injection unit for injecting a process gas into the processing space, wherein the substrate support unit includes a heater for heating the seated substrate, and a current, voltage and power measurement module for measuring an RF voltage, current, and power of an incident wave and a reflected wave generated by plasma in the processing space is installed adjacent to a heater power line for supplying power to the heater.

## Description

### BACKGROUND

The present invention relates to a substrate processing equipment, and more particularly, to a substrate processing equipment equipped with a current voltage and power measurement module for measuring the current/voltage applied for generating and maintaining plasma during substrate processing using plasma, and further for measuring the power of incident and reflected waves.

A substrate processing equipment refers to an equipment that processes a substrate by forming a plasma state in a sealed processing space. The substrate processing equipment may include a plasma source having various structures, such as Capacitively Coupled Plasma (CCP) and Inductively Coupled Plasma (ICP), depending on the plasma formation principle.

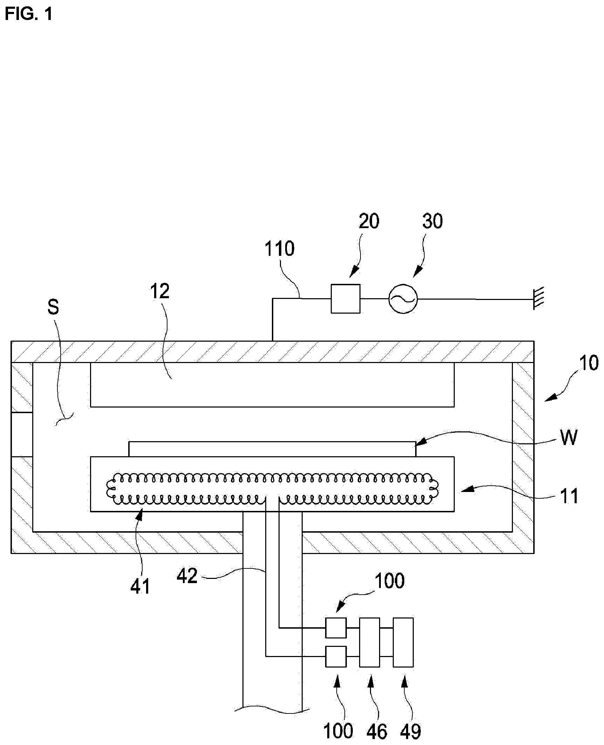

For example, as shown in FIG. 1, a substrate processing equipment generally includes: a process chamber 10 that forms a sealed processing space S in which plasma is formed to process a substrate; a substrate support unit 11 which is disposed in the processing space S and on which a substrate W is placed; and a gas injection unit 12 that injects gas for performing a process into the processing space S.

Meanwhile, various methods for monitoring the plasma state to control the plasma formed in the processing space S are suggested to perform uniform and reproducible substrate processing.

A VI probe is provided as a means for directly measuring the plasma state generated in the processing space S of a substrate processing equipment. Although the conventional VI probe secures accuracy in RF voltage/current measurement, it has a problem in that it is difficult to secure reliability for transmitted power measurement with the conventional technology that calculates transmitted power as IVcos(θ) by measuring the phase difference from the RF voltage and current waveforms.

That is, the conventional commercialized method for measuring transmitted power using phase difference (VI probe), which is used to measure the plasma state generated in the processing space S of the substrate processing equipment, has many difficulties in accurately measuring and controlling the RF power delivered to the plasma.

### SUMMARY

An object of the present invention is to provide a substrate processing equipment capable of measuring the power applied for plasma formation, which is configured to have both capacitor and inductor properties to detect scalar values, i.e., the amount of forward power and reflect power, rather than relying on the principle of vectors, such as detecting the phase difference between voltage and current for RF power measurement.

To achieve the above object, the present invention discloses a substrate processing equipment comprising: a process chamber 10 forming a sealed processing space S in which plasma is formed to perform substrate processing; a substrate support unit 11 disposed in the processing space S on which a substrate W is seated; and a gas injection unit 12 for injecting a process gas into the processing space S, wherein the substrate support unit 11 includes a heater 41 for heating the seated substrate W, and a current, voltage and power measurement module 100 for measuring an RF voltage, current, and power of an incident wave and a reflected wave generated by plasma in the processing space S is installed adjacent to a heater power line 42 for supplying power to the heater 41.

The current, voltage and power measurement module 100 may include a first directional coupler 300 for measuring the voltage output by the reflected wave and a second directional coupler 400 for measuring the current output by the reflected wave.

An RF filter 46 may be additionally installed to block RF energy generated by the RF current from the power source 30 from being transmitted through the heater power line 42 to a heater power supply 49 for supplying power to the heater 41.

Further, the current, voltage and power measurement module 100 and the RF filter 46 may be configured as a single module.

The RF filter 46 may be installed on the PCB 220 that constitutes the current, voltage and power measurement module 100.

The present invention also discloses a current, voltage and power measurement module 100 for a substrate processing equipment having the above configuration, wherein an RF filter 46 for blocking RF energy, which is generated by RF current from a power source 30 and transmitted through a heater power line 42 to a heater power supply 49, is configured as a single module with the current, voltage and power measurement module 100.

### BRIEF DESCRIPTION OF THE FIGURES

FIG. 1 is a conceptual view illustrating an example of a substrate processing equipment according to the present invention.
FIG. 2 is a perspective view illustrating an example of a PCB of the current, voltage and power measurement module.
FIGS. 3a and 3b are a plan view and a rear view, respectively, of the PCB of FIG. 2.
FIG. 4a is a conceptual view illustrating a concept realized as a circuit on the PCB of FIG. 2.
FIG. 4b is an enlarged perspective view of portion A of FIG. 4a.
FIG. 4c is an enlarged perspective view of portion B of FIG. 4a.
FIG. 5 is a cross-sectional view taken along line V-V of FIG. 2.
FIG. 6 is a cross-sectional view illustrating an inductance part of a current measurement unit of FIG. 2.
FIG. 7 is an equivalent circuit diagram of a first directional coupler and a second directional coupler of the measurement module.
FIG. 8 is an equivalent circuit diagram of a voltage measurement unit and a current measurement unit of the measurement module.

### DETAILED DESCRIPTION

Hereinafter, a substrate processing equipment according to the present invention will be described with reference to the accompanying drawings.

First, the substrate processing equipment according to the present invention is an equipment that performs a predetermined function by forming plasma, and it can have various configurations depending on the application of the plasma.

For example, the substrate processing equipment according to the present invention is an equipment that performs substrate processing such as deposition and etching by forming plasma in a processing space S. It can have various configurations for plasma formation structures such as Inductively Coupled Plasma (ICP) and Capacitively Coupled Plasma (CCP).

The substrate processing equipment, as an example shown in FIG. 1, may include: a process chamber 10 that forms a sealed processing space S in which plasma is formed to perform substrate processing; a substrate support unit 11 disposed in the processing space S on which a substrate W is seated; a gas injection unit 12 that injects a gas for performing a process into the processing space S; and at least one power source 30 for applying an RF current of a predetermined frequency to at least one of the substrate support unit 11 and the gas injection unit 12.

The process chamber 10 is a component that forms a sealed processing space S where substrate processing is performed, and various configurations are possible. For example, the process chamber 10 may consist of a container where the processing space S is formed and an upper lid detachably coupled to the upper side of the container.

The substrate support unit 11 is a component installed in the processing space S on which the substrate W is seated, and various configurations are possible. For example, the substrate support unit 11 may include a susceptor part on which the substrate W is seated and a support rod part extending from the bottom surface of the susceptor part to support it. In particular, the substrate support unit 11 is equipped with a heater 41 for heating the seated substrate W.

The heater 41 is a component installed in the substrate support unit 11 that is supplied with power by a heater power line 42 connected to a heater power supply 49 to heat the seated substrate W, and it can have various configurations. Furthermore, the heater 41 may be installed in various patterns to perform uniform substrate processing on the seated substrate W.

Meanwhile, as RF power is applied for plasma formation in the processing space S, RF energy can be transmitted through the heater power line 42 connected to the heater 41 to the heater power supply 49, which can cause energy loss as well as damage or malfunction of the heater power supply 49. Accordingly, it is preferable that the heater power line 42 is additionally provided with an RF filter 46 to block RF energy generated by the RF current applied by the power source 30 from being transmitted through the heater power line 42 to the heater power supply 49. The RF filter 46 is a component installed on the heater power line 42 for this purpose and may be configured by at least one of a coil and a capacitor.

The gas injection unit 12 is a component for injecting a process gas into the processing space S, and various configurations are possible depending on the gas injection structure. For example, the gas injection unit 12 may be configured as a showerhead that injects gas supplied through a gas supply pipe installed above it in a downward direction.

The power source 30 is a component, of which one or more are installed to apply an RF current of a predetermined frequency to at least one of the substrate support unit 11 and the gas injection unit 12, and various configurations are possible depending on the power application method and applied frequency. The one or more RF power sources 30 apply RF power to at least one of the process chamber 10, the gas support unit 11, and the gas injection unit 12, and a matching network 20 is installed between the RF power source 30 and a power application line 110. And the RF power source 30 can supply RF current of a predetermined frequency such as high frequency and low frequency depending on the process conditions.

Meanwhile, as described above, RF current is applied to form plasma in the processing space S, and the RF energy generated by the applied RF current can be transmitted to the heater power supply 49 through the heater power line 42.

Accordingly, the substrate processing equipment according to the present invention allows for the measurement of RF voltage, current, and the power of incident and reflected waves generated by the plasma in the processing space S by installing a current, voltage and power measurement module 100 on the heater power line 42.

The current, voltage and power measurement module 100, as shown in FIG. 1, is characterized by being installed adjacent to the heater power line 42 to measure the RF voltage, current, and power of the incident and reflected waves generated by the plasma in the processing space S. Here, the module 100 can have various configurations depending on the measurement principles for current, voltage, and particularly power.

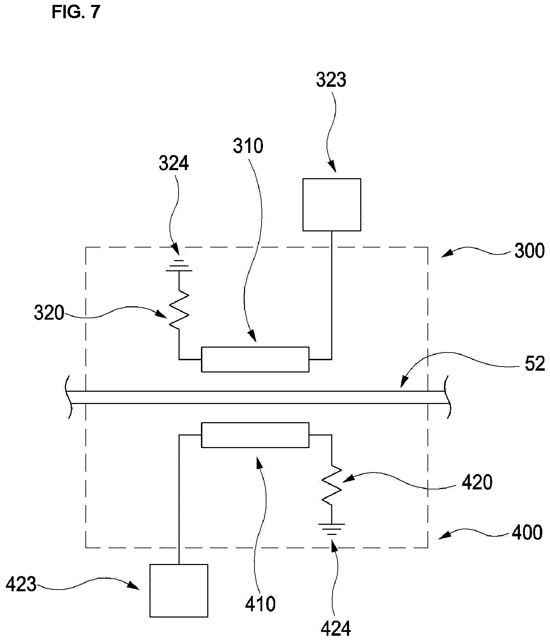

For example, as shown in FIGS. 7 to 8, the module 100 may include: a first directional coupler 300 disposed adjacent to the heater power line 42 to measure the power output by an incident wave; a second directional coupler 400 disposed adjacent to the heater power line 42 to measure the power output by a reflected wave; a voltage measurement unit 500 disposed adjacent to the heater power line 42 to measure the RF voltage using a capacitance principle; and a current measurement unit 600 disposed adjacent to the heater power line 42 to measure the RF current using an inductance principle.

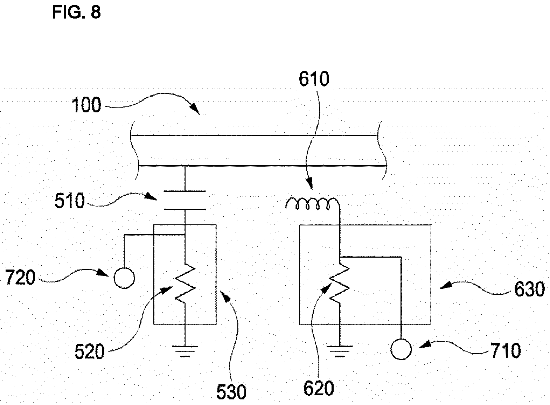

The voltage measurement unit 500 is a component disposed adjacent to the heater power line 42 to measure the RF voltage using the capacitance principle, and various configurations are possible. For example, the voltage measurement unit 500, as shown in FIG. 8, may include a capacitance part 510 disposed adjacent to the heater power line 42, and a third output port part 720 connected to the capacitance part 510 to measure the voltage of the incident wave. The capacitance part 510 is a component disposed adjacent to the heater power line 42 and can have various configurations, such as being made of a capacitor conductor like copper, installed at a predetermined distance from the outer circumference of the heater power line 42 to form a capacitor in the circuit. Of course, a dielectric material for adjusting the dielectric constant may be formed between the outer circumferential surface of the heater power line 42 and the capacitor conductor. The third output port part 720 is a component connected to the capacitance part 510 to measure the voltage of the incident wave applied to the heater power line 42, and various configurations are possible. Particularly, the third output port part 720 may be formed as a wire pattern at the edge of a PCB 220 described later. It is preferable that the third output port part 720 is connected to the midpoint based on the length of the capacitance part 510. Meanwhile, at least one of a resistance element part 520 and a third filter part 530 may be installed between a branch point between the third output port part 720 and the capacitance part 510 and a first ground part 740. The first ground part 740 is a component for grounding through coupling with an external terminal and may be configured similarly to the ground terminal described later. The resistance element part 520 and the third filter part 530 are electrical elements installed to stably measure the voltage of the incident wave from the electrical signal output to the third output port part 720; the third filter part 530 may be configured by a combination of a resistor, a capacitor, a coil, and the like.

The current measurement unit 600 is a component disposed adjacent to the heater power line 42 to measure the RF current using the inductance principle, and various configurations are possible. For example, the current measurement unit 600, as shown in FIG. 8, may include an inductance part 610 disposed adjacent to the heater power line 42, and a fourth output port part 710 connected to the inductance part 610 to measure the current flowing through the heater power line 42. The inductance part 610 is a component disposed adjacent to the heater power line 42 and can have various configurations, such as being made of an inductance wire like copper, installed at a predetermined distance from the outer circumference of the heater power line 42 to form an inductance in the circuit. The fourth output port part 710 is a component connected to the inductance part 610 to measure the current flowing through the heater power line 42, and various configurations are possible. Particularly, the fourth output port part 710 may be formed as a wire pattern at the edge of the PCB 220 described later. It is preferable that the fourth output port part 710 is connected to one end based on the length of the inductance part 610. Meanwhile, at least one of a resistance element part 620 and a fourth filter part 630 may be installed between a branch point between the fourth output port part 710 and the inductance part 610 and a second ground part 730. The second ground part 730 is a component for grounding through coupling with an external terminal and may have a configuration similar to that of the ground terminal described later. The resistance element part 520 and the third filter part 530 are electrical elements installed to stably measure the voltage of the incident wave from the electrical signal output to the third output port part 720; the third filter part 530 may be configured by a combination of a resistor, a capacitor, a coil, and the like.

The first directional coupler 300 is a component disposed adjacent to the heater power line 42 to measure the power output by the incident wave, and various configurations are possible. For example, the first directional coupler 300, as shown in FIG. 8, may include: an LC combination circuit part 310 in which a capacitance element 311 and an inductance element 312, which are disposed adjacent to the heater power line 42 and interact with it, are combined and wound based on the direction of the incident wave flowing through the heater power line 42; and a resistance element part 320 including a first reference resistance element 321 with one end grounded and the other end connected to one end of the LC combination circuit part 310, and a second reference resistance element 322 with one end connected to a first output port 323 and the other end connected to one end of the LC combination circuit part 310. The LC combination circuit part 310 can have various configurations, particularly being formed by a combination of the capacitance element 311 and the inductance element 312. It is preferable that the inductance element 312 has a counter-clockwise winding structure with respect to the traveling direction of the incident wave. Also, if the capacitance element 311 and the inductance element 312 form one coil, a plate surface may be formed toward the outer circumferential surface of the heater power line 42 so that a portion of the coil forms a capacitor part. The resistance element part 320 has various possible configurations. The first reference resistance element 321 may have a preset resistance value, e.g., 50Ω. When installed on a PCB 220, it may be formed as a ground terminal 324. The second reference resistance element 322 may have the same resistance value as the first. The first output port 323 may be formed as a terminal on the edge of the PCB 220. Meanwhile, the first directional coupler 300 may have at least one filter part 330, composed of a capacitor, coil, etc., installed at a branch point between the resistance element part 320 and the LC combination circuit part 310.

The second directional coupler 400 is a component disposed adjacent to the heater power line 42 to measure the power output by the reflected wave, and various configurations are possible. For example, the second directional coupler 400, as shown in FIG. 8, may include: an LC combination circuit part 410 in which a capacitance element 411 and an inductance element 412, which are disposed adjacent to the heater power line 42 and interact with it, are combined and which is wound based on the direction of the reflected wave flowing through the heater power line 42; and a resistance element part 420 including a third reference resistance element 421 with one end grounded and the other end connected to one end of the LC combination circuit part 410, and a fourth reference resistance element 422 with one end connected to a second output port 423 and the other end connected to one end of the LC combination circuit part 410. The inductance element 412 is preferably wound counter-clockwise with respect to the traveling direction of the reflected wave, making its winding direction opposite to that of the inductance element 312 of the first directional coupler 300. The third reference resistance element 421 may have a preset resistance value, e.g., 50Ω, and may be formed as a ground terminal 424 on the PCB 220. The fourth reference resistance element 422 may have the same resistance value as the third. The second output port 423 may be formed as a terminal on the edge of the PCB 220. Meanwhile, the second directional coupler 400 may have at least one filter part 430, composed of a capacitor, coil, etc., installed at a branch point between the resistance element part 420 and the LC combination circuit part 410.

Meanwhile, the substrate processing equipment according to the present invention having the above configuration may be configured as a single module including one PCB 220. That is, it may include a PCB 220 with an insertion part 210 having an inner diameter larger than the outer diameter of the heater power line 42 so that at least a portion of the heater power line 42 can be inserted. The insertion part 210 can have various shapes, such as an arc or circle, considering the circular cross-section of the heater power line 42, or a polygonal shape for a rectangular cross-section.

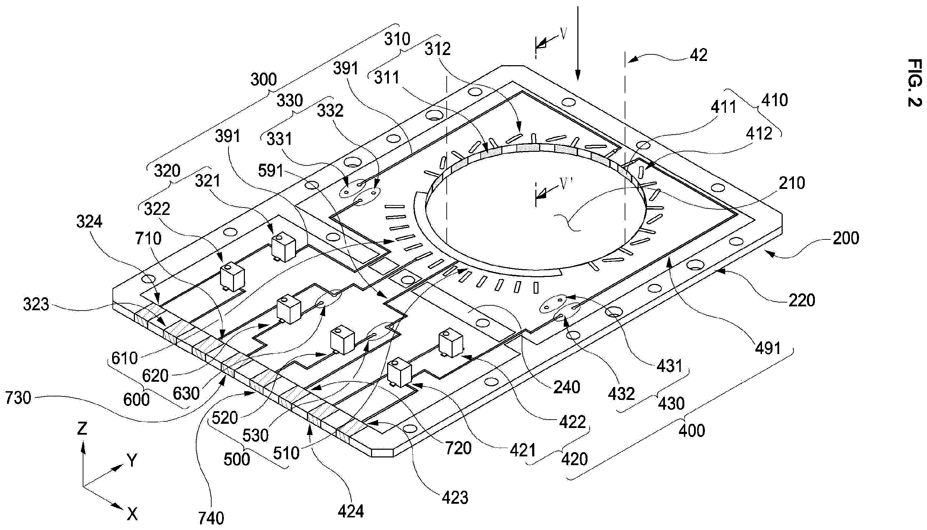

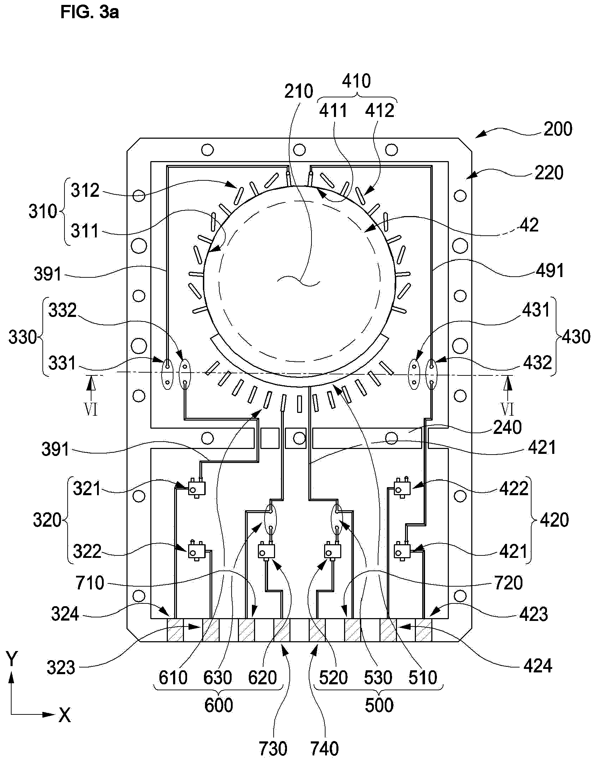

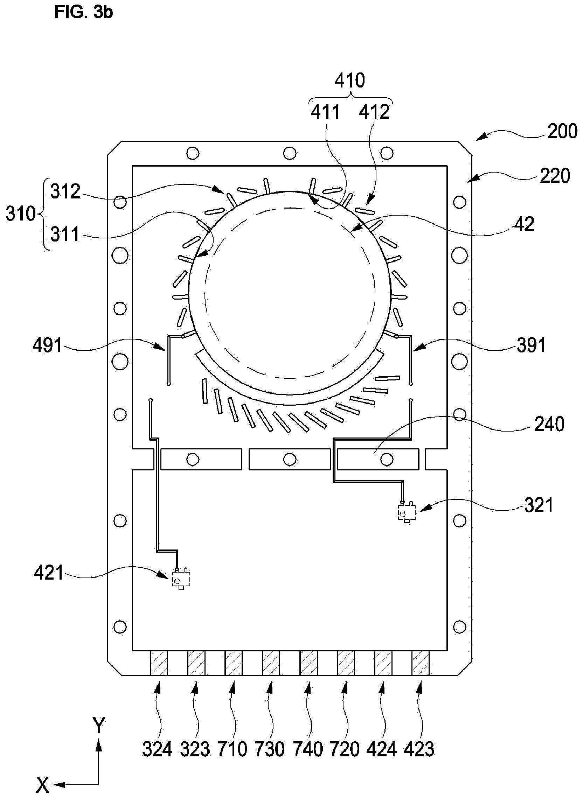

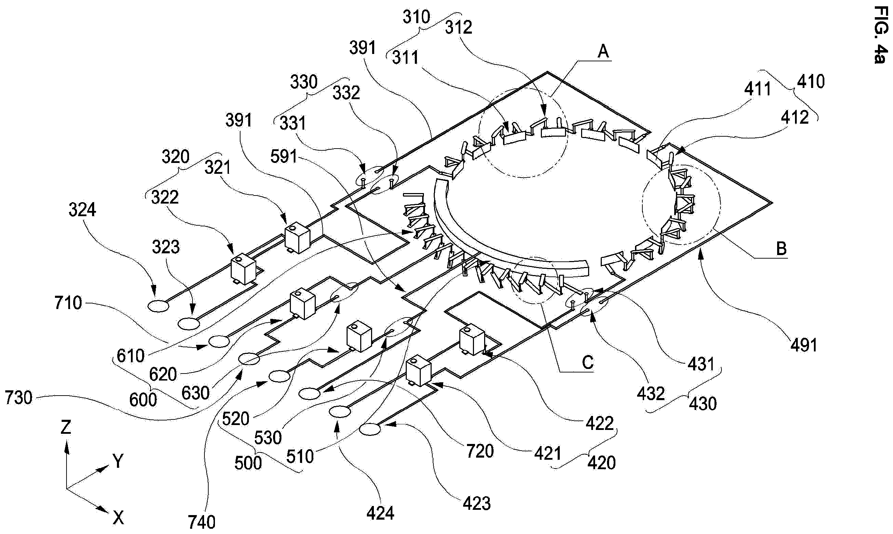

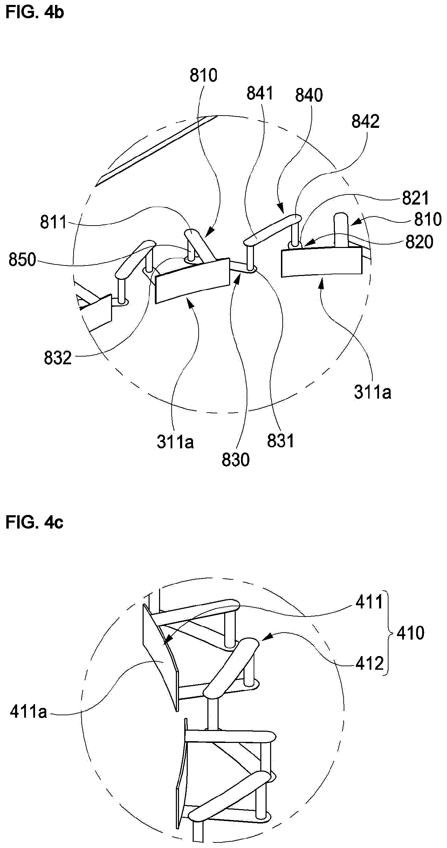

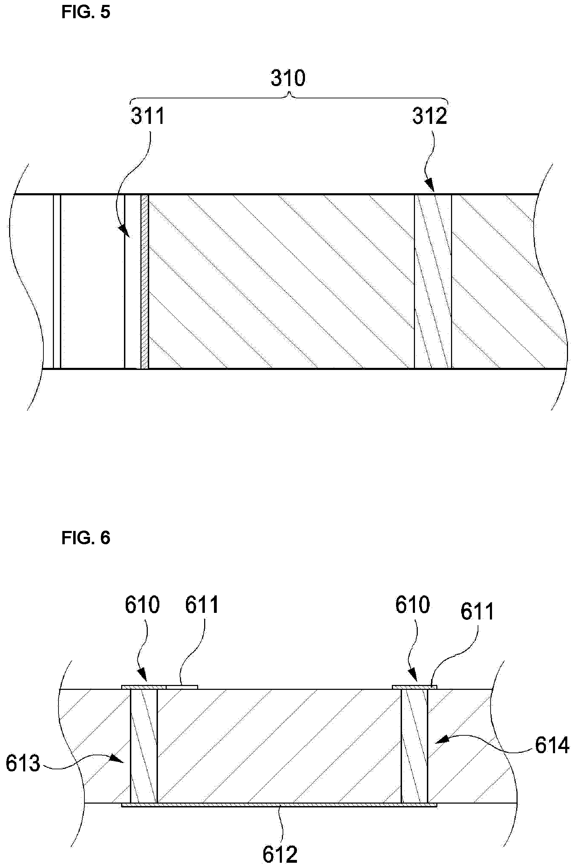

Meanwhile, the capacitance element 311 of the first directional coupler 300 and the capacitance element 411 of the second directional coupler 400, as shown in FIGS. 2 to 5, include a plurality of capacitance parts 311a, 411a spaced apart along the circumferential direction on the inner circumferential surface of the insertion part 210. The inductance element 312 of the first directional coupler 300 and the inductance element 412 of the second directional coupler 400 include winding parts 340, 440 that pass through the PCB 220 and are wound at least once to connect the ends of adjacent capacitance parts 311a, 411a. In a specific embodiment, the winding parts 340, 440 may include metal pattern parts 810, 820, 830, 840 on the top and bottom surfaces of the PCB 220 and vertical connection parts 850 passing through the PCB 220 to electrically connect them. For example, the metal patterns may include a first upper component 810, a first lower component 820, a second lower component 830, and a second upper component 840, which are connected by multiple vertical connection members 850 to form a coil structure. The metal pattern part 441 and vertical connection part 442 of the second directional coupler 400 are formed with line symmetry to those of the first directional coupler 300 with respect to the center of the insertion part 210, for which a detailed description is omitted.

On the PCB 220, the LC combination circuit parts 310, 410 may be on one side, and the resistance element parts 320, 420 and filter parts 330, 430 may be on the other side. The PCB 220 may be divided into a first area for the LC circuits and a second area for the resistance elements, connected by wire patterns 390, 490. A shielding wire pattern 240 may be formed between the areas.

The voltage measurement unit 500 can be merged into the PCB 220. The capacitance part 510 can be formed in the first area on the inner circumferential surface of the insertion part 210. The resistance element part 520 can be installed in the second area and connected by a wire pattern 590. The third filter part 530 can be placed at a branch point on the wire pattern 590.

The current measurement unit 600 can also be merged into the PCB 220. The inductance part 610 can be formed in the first area, concentric with but further from the insertion part 210 than the voltage measurement unit 500. Specifically, it can comprise a plurality of upper components 611, lower components 612, and first and second connection parts 613, 614. The resistance element part 620 can be installed in the second area and connected by a wire pattern 690. The fourth filter part 630 can be placed at a branch point on the wire pattern 690.

Terminals for the first output port 323, ground terminal 324, second output port 423, ground terminal 424, first ground part 740, second ground part 730, third output port 720, and fourth output port 710 can be formed on the edge of the second area of the PCB 220.

The current, voltage and power measurement module 100 can measure the power of the incident and reflected waves using the first directional coupler 300 and the second directional coupler 400. However, since the output signals contain noise, proper extraction and verification are required. Therefore, the module 100 can measure the voltage and current applied to the heater power line 42, and the power of the incident and reflected waves, through a pre-established lookup table, relational expressions, etc., obtained from experiments.

While a configuration including all measurement units has been described, the present invention can, of course, be configured by a combination of at least one of the voltage measurement unit 500, current measurement unit 600, first directional coupler 300, and second directional coupler 400 as needed. In particular, any combination of these can be implemented on a single PCB.

Meanwhile, as described before, an RF filter 46 can be additionally installed to block RF energy from being transmitted to the heater power supply 49. In this case, the measurement module 100 and the RF filter 46 can be configured as a single module. In particular, the RF filter 46 can be installed on the PCB 220 of the measurement module 100.

The above is a description of only some of the preferred embodiments that can be implemented by the present invention, and as is well known, the scope of the present invention should not be interpreted as being limited to the above embodiments, and all technical ideas that share the fundamental technical spirit of the present invention described above shall be included in the scope of the present invention.

## Claims

1. A substrate processing equipment, comprising:
a process chamber forming a sealed processing space in which plasma is formed to perform substrate processing;
a substrate support unit disposed in the processing space on which a substrate is seated;
a gas injection unit configured to inject a gas for performing a process into the processing space; and
at least one power source for applying an RF current of a predetermined frequency to at least one of the substrate support unit and the gas injection unit,
wherein the substrate support unit includes a heater for heating the seated substrate, and
a current, voltage and power measurement module for measuring an RF voltage, current, and power of an incident wave and a reflected wave generated by plasma in the processing space is installed adjacent to a heater power line for supplying power to the heater.

2. The substrate processing equipment of claim 1, wherein the current, voltage and power measurement module comprises:
a first directional coupler disposed adjacent to the heater power line to measure power output by an incident wave;
a second directional coupler disposed adjacent to the heater power line to measure power output by a reflected wave;
a voltage measurement unit disposed adjacent to the heater power line to measure an RF voltage by using capacitance; and
a current measurement unit disposed adjacent to the heater power line to measure an RF current by using inductance.

3. The substrate processing equipment of claim 2, wherein the first directional coupler and the second directional coupler comprise inductance elements having different winding directions.

4. The substrate processing equipment of claim 3, wherein the first directional coupler comprises:
an LC combination circuit part in which a capacitance element and an inductance element, which are disposed adjacent to the heater power line and interact with the heater power line, are combined and which is wound based on a direction of the incident wave flowing through the heater power line; and
a resistance element part comprising a first reference resistance element having one end that is grounded and the other end connected to one end of the LC combination circuit part and a second reference resistance element having one end connected to a first output port and the other end connected to one end of the LC combination circuit part, and
the second directional coupler comprises:
an LC combination circuit part in which a capacitance element and an inductance element, which are disposed adjacent to the heater power line and interact with the heater power line, are combined and which is wound based on a direction of the reflected wave flowing through the heater power line; and
a resistance element part comprising a third reference resistance element having one end that is grounded and the other end connected to one end of the LC combination circuit part and a fourth reference resistance element having one end connected to a second output port and the other end connected to one end of the LC combination circuit part.

5. The substrate processing equipment of claim 4, wherein the first directional coupler comprises at least one filter part disposed at a branch point branched between the resistance element part and the LC combination circuit part, and
the second directional coupler comprises at least one filter part installed at a branch point branched between the resistance element part and the LC combination circuit part.

6. The substrate processing equipment of claim 4, further comprising a PCB in which an insertion part having an inner diameter greater than an outer diameter of the heater power line so that at least a portion of the heater power line is inserted thereto,
wherein a capacitance element of the first directional coupler and a capacitance element of the second directional coupler comprise a plurality of capacitance parts spaced apart from each other along a circumferential direction on an inner circumferential surface of the insertion part, and
an inductance element of the first directional coupler and the inductance element of the second directional coupler comprise winding parts passing through the PCB and wound at least one time to connect the ends of adjacent capacitance parts.

7. The substrate processing equipment of claim 6, wherein the winding parts comprise metal pattern parts formed on top and bottom surfaces of the PCB and vertical connection parts passing through the PCB in a vertical direction to electrically connect the metal pattern parts.

8. The substrate processing equipment of claim 6, wherein the voltage measurement unit comprises:
a capacitance part formed in a circumferential direction at a predetermined angle on at least one of an inner circumferential surface of the insertion part and top and bottom surfaces of an edge of the insertion part; and
a third output port part connected to the capacitance part.

9. The substrate processing equipment of claim 8, wherein at least one of a resistance element part and a third filter part is disposed between a first ground part and a branch point between the capacitance part and the third output port part.

10. The substrate processing equipment of claim 7, wherein the current measurement unit comprises:
an inductance part passing through the PCB in concentric with the voltage measurement unit further away from the voltage measurement unit based on the inner circumferential surface of the insertion part and winding at least one time; and
a fourth output port part connected to the inductance part.

11. The substrate processing equipment of claim 10, wherein at least one of a resistance element part and a fourth filter part is disposed between a second ground part and a branch point between the inductance part and the fourth output port part.

12. The substrate processing equipment of any one of claims 1 to 11, further comprising an RF filter installed to block RF energy generated by RF current applied by the power source from being transmitted through the heater power line to a heater power supply for supplying power to the heater.

13. The substrate processing equipment of claim 12, wherein the current, voltage and power measurement module and the RF filter are configured as a single module.

14. The substrate processing equipment of claim 13, wherein the RF filter is installed on a PCB that constitutes the current, voltage and power measurement module.

15. A current, voltage and power measurement module for a substrate processing equipment according to any one of claims 1 to 11, wherein an RF filter, for blocking RF energy generated by RF current applied by a power source from being transmitted through a heater power line to a heater power supply, is configured as a single module with the current, voltage and power measurement module.
